# EUROPEAN PATENT APPLICATION

(11) **EP 4 366 356 A1**
(43) Date of publication of application: **08.05.2024**
(21) Application number: 21948242.9
(22) Date of filing: 28.06.2021
(51) Int. Cl.: H04W 16/18

(54) **AREA DESIGNING ASSISTANCE METHOD, AREA DESIGNING ASSISTANCE DEVICE, AND PROGRAM**

(71) Applicant: Nippon Telegraph And Telephone Corporation, Chiyoda-ku Tokyo 100-8116 (JP)
(72) Inventor: TOSHINAGA, Hideki, Musashino-shi, Tokyo 180-8585 (JP); TSUBOI, Hideyuki, Musashino-shi, Tokyo 180-8585 (JP); GOTO, Kazuto, Musashino-shi, Tokyo 180-8585 (JP); KITA, Naoki, Musashino-shi, Tokyo 180-8585 (JP)
(74) Representative: Brevalex
(86) International application number: PCT/JP2021/024334
(87) International publication number: WO 2023/275928

(57) **Abstract**

An area design assistance method includes: an evaluation range determination step of determining an evaluation range on a map generated from map information; a mesh creation step of creating a mesh group that divides the evaluation range; a representative point determination step of determining a representative point of the mesh; a visibility decision step of deciding visibility between a base station and the representative point based on an outline of a building included in the evaluation range; and a communication availability decision step of deciding communication availability between the base station and the representative point by using point cloud data in a region corresponding to the map information for the representative point decided as having the visibility by the visibility decision step.

## Description

### Technical Field

The present invention relates to an area design assistance method (an area design auxiliary method), an area design assistance device (an area design auxiliary device), and a program.

### Background Art

Proposals have been made to utilize millimeter waves for the infrastructure of communication networks, and efforts have been made to construct wireless infrastructure by using high frequency bands such as millimeter waves.

In a technology of designing a base station, communication availability is generally determined on the basis of whether there is a shielding object between a base station and a point where evaluation is performed (for example, Patent Literature 1). There is a technology of monitoring a state of an infrastructure facility by utilizing point cloud data (for example, Non Patent Literature 1).

### Citation List

### Patent Literature

Patent Literature 1: JP 2006-352551 A
Patent Literature 2: JP 2020-107955 A

### Non Patent Literature

Non Patent Literature 1: 2017 NTT R&D Forum Exhibition Panel B-10 https://labevent.ecl.ntt.co.jp/forum2017/elements/pdf_jpn/02/B-10_j.pdf

### Summary of Invention

### Technical Problem

However, in wireless communication, since radio waves spread and propagate in the Fresnel zone, communication may be possible even when there is a shielding object between a base station and radio waves.

The present invention provides an area design assistance method, an area design assistance device, and a program for achieving area design by utilizing point cloud data.

### Solution to Problem

An aspect of the present invention is an area design assistance method including: an evaluation range determination step of determining an evaluation range on a map generated from map information; a mesh creation step of creating a mesh group that partitions the evaluation range; a representative point determination step of determining a representative point of the mesh; a visibility decision step of deciding visibility between a base station and the representative point on the basis of an outline of a building included in the evaluation range; and a communication availability decision step of deciding communication availability between the base station and the representative point by using point cloud data in a region corresponding to the map information for the representative point determined to have the visibility by the visibility decision step.

An aspect of the present invention is an area design assistance device including: an evaluation range determination unit that determines an evaluation range on a map generated from map information; a mesh creation unit that creates a mesh group that divides the evaluation range; a representative point determination unit that determines a representative point of the mesh; a visibility decision unit that decides visibility between a base station and the representative point on the basis of an outline of a building included in the evaluation range; and a communication availability decision unit that decides communication availability between the base station and the representative point by using point cloud data in a region corresponding to the map information for the representative point determined to have the visibility by the visibility decision unit.

An aspect of the present invention is a program for causing a computer to function as the area design assistance method.

### Advantageous Effects of Invention

According to the present invention, area design can be achieved by utilizing point cloud data.

### Brief Description of Drawings

Fig. 1 is a diagram illustrating a configuration of an area design assistance device 1 according to a first embodiment.
Fig. 2 is an example of a map divided by a mesh.
Fig. 3 is an example of a mesh in which a representative point is determined.
Fig. 4 is an example of a possibility position of a base station generated on a map.
Fig. 5 is an example of a mesh decided as having visibility or not having visibility.
Fig. 6 is a flowchart illustrating an operation of an area design assistance device 1.
Fig. 7A is a schematic diagram of a decision method of a mesh by a communication availability decision unit 28 according to a second embodiment.
Fig. 7B is a schematic diagram of a decision method of a mesh by the communication availability decision unit 28 according to the second embodiment.
Fig. 8 is an example of a triangle formed by a base station, an outline of a building, two line segments connecting the base station and both ends of the outline of the building and the outline of the building.

### Description of Embodiments

### <First Embodiment>

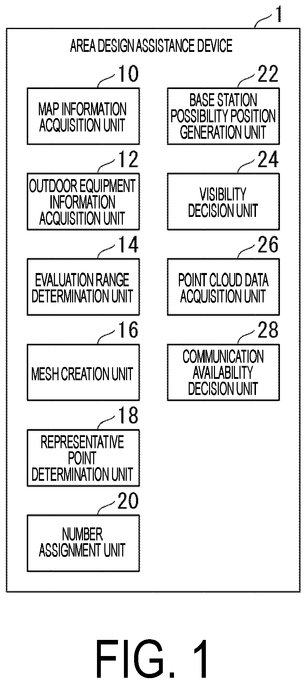

Fig. 1 is a diagram illustrating a configuration of an area design assistance device 1 according to a first embodiment. The area design assistance device 1 provides information that assists in designing a communication area on the basis of input map information or the like.

The area design assistance device 1 includes a map information acquisition unit 10, an outdoor equipment information acquisition unit 12, an evaluation range determination unit 14, a mesh creation unit 16, a representative point determination unit 18, a number assignment unit 20, a base station possibility position generation unit 22, a visibility decision unit 24, a point cloud data acquisition unit 26, and a communication availability decision unit 28.

The map information acquisition unit 10 acquires map information. The map information includes, for example, information on the outline of a building on the map. The outline of the building on the map is, for example, the shape of a wall surface of an office, a factory, a house, or the like on the map. The map information may be information on a two-dimensional map or information on a three-dimensional map. When the map information is information on a three-dimensional map, the map information may include information on a height of a building on the map. The map information acquisition unit 10 acquires, for example, map information input by a user.

The outdoor equipment information acquisition unit 12 acquires outdoor equipment information. The outdoor equipment information may include information on a place of a communication equipment such as a utility pole or a communication cable which is located outdoors, information on a place of an existing wireless base station, a structure in which a wireless base station can be installed, or the like. The outdoor equipment information acquisition unit 12 acquires, for example, outdoor equipment information input by a user, the outdoor equipment information being information on a structure or the like as a possibility for installing a wireless base station.

The evaluation range determination unit 14 determines an evaluation range on a map generated from the map information. The evaluation range is a range in which area design is performed. The evaluation range is designated, for example, by enclosing a place where the user desires to evaluate on a screen on which a map acquired by the map information acquisition unit 10 is displayed, and is determined by the evaluation range determination unit 14 on the basis of the designated range.

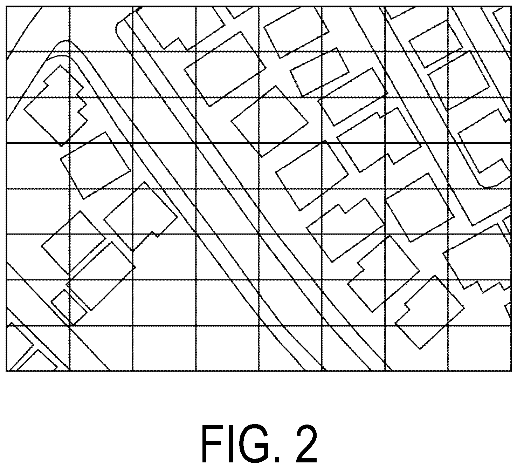

The mesh creation unit 16 creates a mesh that divides the evaluation range determined by the evaluation range determination unit 14. The mesh creation unit 16 creates a mesh group that divides the evaluation range by spreading the evaluation ranges by using, for example, meshes having a predetermined size. The mesh creation unit 16 may, for example, adjust the size of a predetermined number of meshes to create a mesh group that divides the evaluation range. Fig. 2 is an example of a map divided by a mesh.

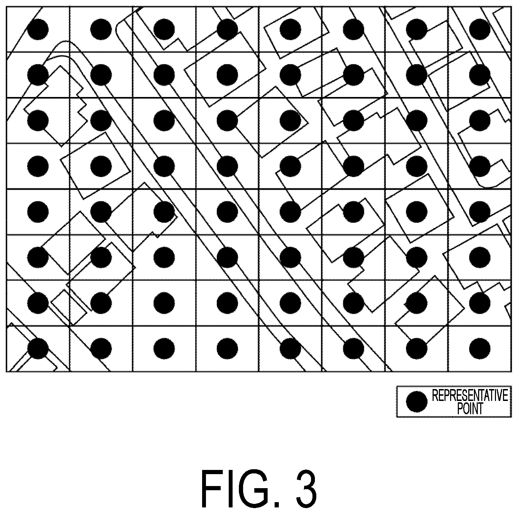

The representative point determination unit 18 determines a representative point for each mesh. For example, when the mesh is square, the representative point determination unit 18 determines the center of the mesh as the representative point. For example, when the map is represented by two-dimensional XY coordinates, the representative point determination unit 18 may determine the smallest X coordinate and Y coordinate included in the mesh as the representative point. Fig. 3 is an example of a mesh in which a representative point is determined.

The number assignment unit 20 assigns numbers to the meshes. The number of the mesh is for distinguishing from other meshes, and thus may be, for example, a symbol or a representative point of the mesh instead of the number.

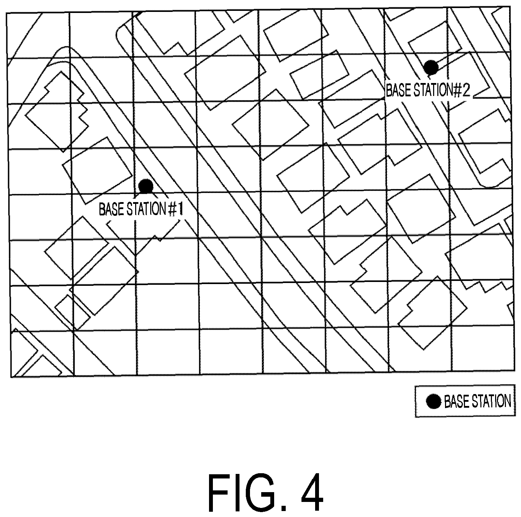

The base station possibility position generation unit 22 generates a possibility position of the base station. The possibility position of the base station is, for example, a position of a utility pole based on outdoor equipment information. The possibility position of the base station may be, for example, a position of a building having a height of a certain value or more among the heights of buildings based on the map information. Fig. 4 is an example of a possibility position of a base station generated on a map.

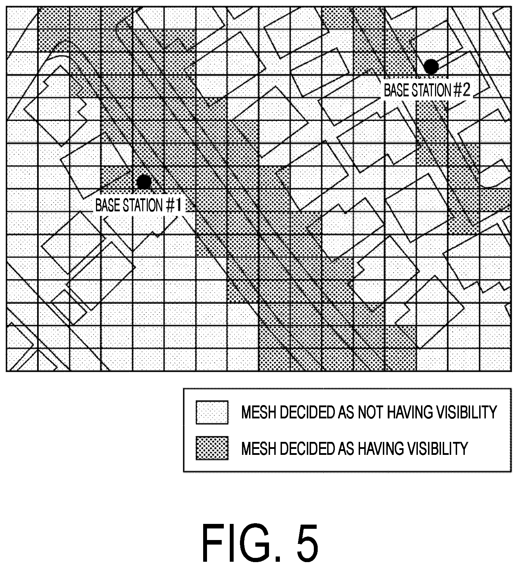

The visibility decision unit 24 decides visibility from the possibility position of the base station to the mesh. For example, the visibility decision unit 24 connects the possibility position of the base station and the representative point of the mesh by a line segment, decides as "not having visibility" when the line segment intersects with the outline of the building, and decides as "having visibility" when the line segment does not intersect with the outline of the building. When the map information acquired by the map information acquisition unit 10 is information on a three-dimensional map, the visibility decision unit 24 may decide visibility from the possibility position of the base station to the mesh in consideration of the possibility position of the base station and the height of the representative point of the mesh. Fig. 5 is an example of a mesh decided as having visibility or not having visibility.

The point cloud data acquisition unit 26 acquires the point cloud data collected in the region corresponding to the map information acquired by the map information acquisition unit 10 on the traveling track by the MMS and the MMS. The region corresponding to the map information is a real region indicated by a map created by the map information.

The communication availability decision unit 28 decides communication availability by using the point cloud data for the possibility position of the base station and the corresponding mesh having visibility. A method for deciding the communication availability is, for example, a method disclosed in Patent Literature 2.

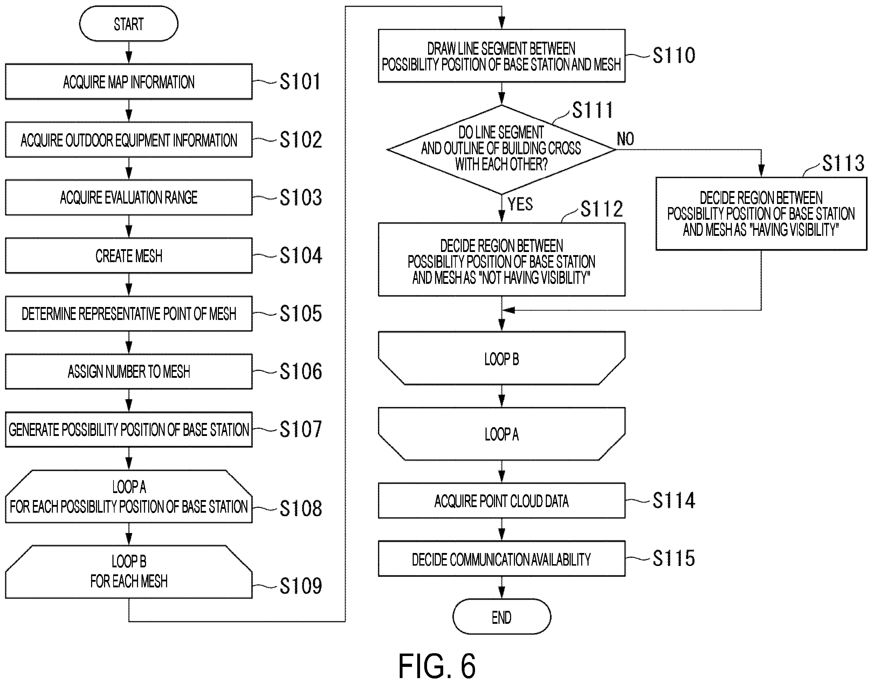

Fig. 6 is a flowchart illustrating an operation of the area design assistance device 1.

The map information acquisition unit 10 acquires map information (step S101). The outdoor equipment information acquisition unit 12 acquires outdoor equipment information (step S102). The evaluation range determination unit 14 determines an evaluation range (step S103). The mesh creation unit 16 creates a mesh (step S104). The representative point determination unit 18 determines a representative point for each mesh (step S105). The number assignment unit 20 assigns numbers to the meshes (step S106). The base station possibility position generation unit 22 generates a possibility position of the base station (step S107).

The visibility decision unit 24 repeats steps S109 to S113 for the possibility position of each base station (step S108). The visibility decision unit 24 repeats steps S110 to S113 for each mesh (step S109). The visibility decision unit 24 decides visibility for all the meshes from the possibility positions of all the base stations in steps S108 and S109.

The visibility decision unit 24 draws a line segment between the possibility position of the base station and the mesh (step S110). The visibility decision unit 24 decides whether the line segment intersects with the outline of the building (step S111). When the line segment intersects with the outline of the building (step S111: YES), the visibility decision unit 24 decides that the region between the possibility position of the base station and the mesh are "not having visibility" (step S112). When the line segment does not intersect with the outline of the building (step S111: NO), the visibility decision unit 24 decides that the region between the possibility position of the base station and the mesh are "having visibility" (step S113).

Thereafter, the point cloud data acquisition unit 26 acquires point cloud data (step S114). The communication availability decision unit 28 evaluates shielding by using the point cloud data (step S115).

As described above, the area design assistance device 1 according to the first embodiment has the above-described configuration, so that the area design can be achieved by utilizing the point cloud data.

### <Second Embodiment>

In addition to the operation of the communication availability decision unit 28 according to the first embodiment, when there is a mesh decided as communication unavailable between a possibility position of the base station and a representative point of the mesh, the communication availability decision unit 28 according to a second embodiment decides that communication between the base station and the representative point is unavailable.

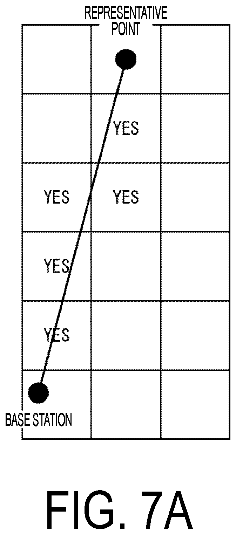

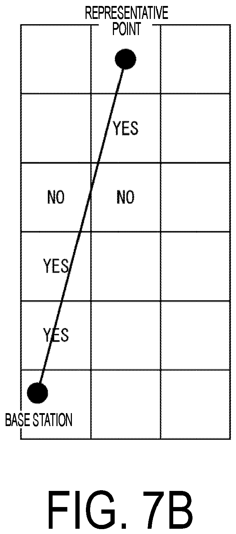

The communication availability decision unit 28 decides the communication availability by using the point cloud data in order from the mesh in which the corresponding representative point is closer to the base station among the possibility positions of the base station and the corresponding mesh having visibility. Figs. 7A and 7B are schematic diagrams of a decision method of a mesh by the communication availability decision unit 28 according to the second embodiment. In Figs. 7A and 7B, a mesh decided as communication available by the point cloud data is indicated as "YES", and a mesh decided as communication unavailable by the point cloud data is indicated as "NO".

In Fig. 7A, since all the meshes through which the line segment drawn between the representative point of the mesh to be decided and the base station passes are "YES", communication availability is decided by using the point cloud data for the mesh corresponding to the representative point as in the first embodiment. However, in Fig. 7B, when a mesh of "NO" is included in meshes through which a line segment drawn between a representative point of the mesh to be decided and the base station passes, the mesh corresponding to the representative point is decided as "NO".

In the area design assistance device 1 according to the second embodiment, when there is a mesh decided as communication unavailable between a possibility position of the base station and a representative point of the mesh, the communication availability decision unit 28 decides that communication between the base station and the representative point is unavailable, so that it is possible to reduce the number of meshes for which communication availability is decided using the point cloud data.

### <Third Embodiment>

A visibility decision unit 24 according to a third embodiment decides visibility between a base station and the representative point in consideration of reflection on an outline of a building.

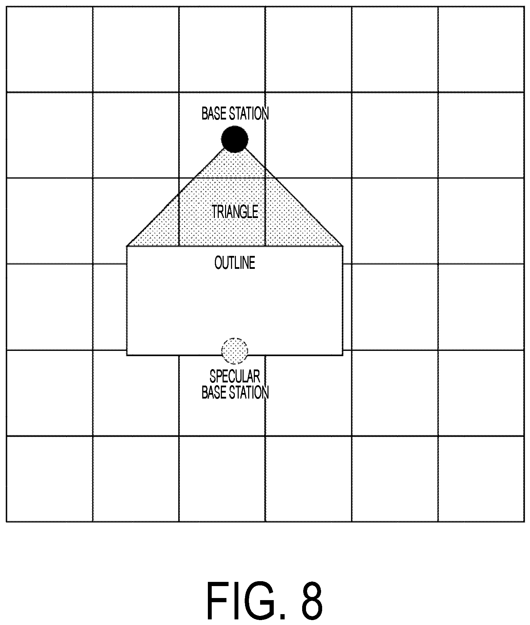

When all the meshes between the base station and the outline of the building are decided as having visibility, the visibility decision unit 24 according to the third embodiment determines the outline as the transmission source of the reflected wave. Here, the fact that all the meshes between the base station and the outline of the building have visibility means that, for example, it is decided that all meshes overlapping with a triangle formed by two line segments connecting the base station and both ends of the outline of the building and the outline of the building have visibility. Fig. 8 illustrates an example of the triangle formed by a base station, an outline of a building, two line segments connecting the base station and both ends of the outline of the building and the outline of the building.

Thereafter, the visibility decision unit 24 installs a specular base station on the map. The specular base station is installed at a position line-symmetric with the base station with the outline determined as the transmission source of the reflected wave as an axis of symmetry. Fig. 8 illustrates an example of the specular base station. Thereafter, the visibility decision unit 24 decides visibility from the specular base station to the mesh by a method similar to the method for the base station.

In the area design assistance device 1 according to the third embodiment, the specular base station is installed on the map and the visibility decision unit 24 decides the visibility from the specular base station to the mesh, so that an area in which communication with the base station is available only by reflection by the outline of the building can be decided as communication available.

Although an embodiment of the present invention has been described in detail with reference to the drawings, specific configurations are not limited to the embodiment, and include designs and the like without departing from the scope of the invention.

A part or all of the area design assistance device 1 in each embodiment described above may be implemented by a computer. In that case, a program for implementing these functions may be recorded in a computer-readable recording medium, and the program recorded in the recording medium may be read and executed by a computer system to implement the functions. Note that the "computer system" mentioned herein includes an OS and hardware such as peripheral devices. The "computer-readable recording medium" refers to a portable medium such as a flexible disk, a magneto-optical disc, a ROM, or a CD-ROM, or a storage device such as a hard disk included in the computer system. The "computer-readable recording medium" may include a medium that dynamically stores the program for a short time, such as a communication line in a case where the program is transmitted via a network such as the Internet or a communication line such as a telephone line, and a medium that stores the program for a certain period of time, such as a volatile memory inside the computer system serving as a server or a client in that case. Also, the foregoing program may be for implementing some of the functions described above, may be implemented in a combination of the functions described above and a program already recorded in a computer system, or may be implemented with a programmable logic device such as a field programmable gate array (FPGA).

### Reference Signs List

- 1: Area design assistance device
- 10: Map information acquisition unit
- 12: Outdoor equipment information acquisition unit
- 14: Evaluation range determination unit
- 16: Mesh creation unit
- 18: Representative point determination unit
- 20: Number assignment unit
- 22: Base station possibility position generation unit
- 24: Visibility decision unit
- 26: Point cloud data acquisition unit
- 28: Communication availability decision unit

## Claims

1. An area design assistance method comprising:
an evaluation range determination step of determining an evaluation range on a map generated from map information;
a mesh creation step of creating a mesh group that partitions the evaluation range;
a representative point determination step of determining a representative point of the mesh;
a visibility decision step of deciding visibility between a base station and the representative point based on an outline of a building included in the evaluation range; and
a communication availability decision step of deciding communication availability between the base station and the representative point by using point cloud data in a region corresponding to the map information for the representative point decided as having the visibility by the visibility decision step.

2. The area design assistance method according to claim 1,
wherein, in the communication availability decision step,
it is decided that communication between the base station and the representative point is unavailable when there is a mesh decided as communication unavailable between the base station and the representative point.

3. The area design assistance method according to claim 1 or 2,
wherein, in the visibility decision step,
the visibility between the base station and the representative point is decided in consideration of reflection on the outline of the building.

4. An area design assistance device comprising:
an evaluation range determination unit that determines an evaluation range on a map generated from map information;
a mesh creation unit that creates a mesh group that divides the evaluation range;
a representative point determination unit that determines a representative point of the mesh;
a visibility decision unit that decides visibility between a base station and the representative point based on an outline of a building included in the evaluation range; and
a communication availability decision unit that decides communication availability between the base station and the representative point by using point cloud data in a region corresponding to the map information for the representative point decided as having the visibility by the visibility decision unit.

5. A program for causing a computer to function as
the area design assistance method according to any one of claims 1 to 3.
